# FASCICULE DE BREVET EUROPEEN

(11) **EP 3 239 983 B1**
(45) Date de publication et mention de la délivrance du brevet: **11.09.2019**
(21) Numéro de dépôt: 17165614.3
(22) Date de dépôt: 07.04.2017
(51) Int. Cl.: G11C 13/00

(54) **MÉMOIRE RÉSISTIVE UNIPOLAIRE**
EINPOLIGER RESISTIVER SPEICHER
UNIPOLAR RESISTIVE MEMORY

(30) Priorité: 29.04.2016 FR 1653902
(43) Date de publication de la demande: 01.11.2017
(73) Titulaire: Commissariat à l'Energie Atomique et aux Energies Alternatives, 75015 Paris (FR)
(72) Inventeur: GIRAUD, Bastien, 38340 Voreppe (FR); LEVISSE, Alexandre, 38000 Grenoble (FR); NOEL, Jean-Philippe, 38330 Montbonnot Saint Martin (FR)
(74) Mandataire: Cabinet Beaumont

(56) Documents cités:
- US-A1- 2010 177 555
- US-A1- 2014 126 265
- US-A1- 2014 268 997
- US-A1- 2015 009 745
- US-A1- 2015 364 193
- US-A1- 2016 056 207

## Description

### Domaine

La présente demande concerne le domaine des circuits électroniques de façon générale, et vise plus particulièrement le domaine des mémoires non volatiles à résistance programmable, couramment appelées mémoires résistives.

### Exposé de l'art antérieur

Les mémoires résistives tirent profit de la capacité qu'ont certains matériaux à changer de résistivité électrique de façon réversible et non volatile sous l'effet d'une polarisation. Une mémoire résistive comprend une pluralité de cellules élémentaires de stockage, chaque cellule comportant au moins un élément résistif de stockage à résistance programmable pouvant présenter au moins deux valeurs différentes de résistance, par exemple une première valeur (ou valeur faible), notée LRS, et une deuxième valeur supérieure à la valeur LRS (ou valeur élevée), notée HRS. Chaque cellule élémentaire comporte en outre classiquement un ou plusieurs transistors de contrôle. L'élément résistif de stockage peut comprendre deux régions conductrices ou électrodes, séparées par une couche d'un matériau à résistance programmable. L'application d'une tension convenablement choisie entre les deux électrodes pendant une durée déterminée permet de modifier la résistance de la couche à résistance programmable. Des données peuvent ainsi être enregistrées dans les cellules sur la base de valeurs de résistance. On appelle opération d'écriture d'une cellule mémoire le fait de faire passer la résistance de l'élément résistif de la cellule de la valeur haute HRS à la valeur basse LRS. On appelle opération d'effacement d'une cellule mémoire le fait de faire passer la résistance de l'élément résistif de la cellule de la valeur basse LRS à la valeur haute HRS.

On distingue deux catégories de mémoires résistives, classiquement appelées mémoires résistives bipolaires et mémoires résistives unipolaires. Dans les mémoires résistives bipolaires, la tension appliquée aux bornes d'un élément résistif d'une cellule lors d'une opération d'écriture et la tension appliquée aux bornes de cet élément lors d'une opération d'effacement sont de polarités opposées. Dans les mémoires résistives unipolaires, la tension appliquée aux bornes d'un élément résistif d'une cellule lors d'une opération d'écriture et la tension appliquée aux bornes de cet élément lors d'une opération d'effacement sont de même polarité, l'état de résistivité (HRS ou LRS) dans lequel est programmé l'élément résistif dépendant essentiellement de la forme de l'impulsion de tension appliquée. On s'intéresse ici plus particulièrement aux mémoires résistives unipolaires. A titre d'exemple, parmi les mémoires résistives unipolaires, on trouve notamment les mémoires résistives à changement de phase, ou mémoires PCM (de l'anglais "Phase Change Memory"), dans lesquelles l'élément résistif de stockage comprend une couche en un matériau à changement de phase, par exemple un verre de chalcogénure, dont l'état cristallin ou amorphe, correspondant respectivement à la valeur de résistance faible LRS et à la valeur de résistance élevée HRS, est modifié par chauffage de ladite couche sous l'effet d'une impulsion de tension appliquée aux bornes de l'élément. L'impulsion de tension appliquée lors d'une opération d'écriture et l'impulsion de tension appliquée lors d'une opération d'effacement sont de même polarité, l'état cristallin ou amorphe dans lequel est programmé l'élément résistif dépendant principalement de la pente du front descendant de l'impulsion.

Les documents US2016/056207 (D1), US2015/364193 (D2) et US2014/268997 (D3) décrivent divers exemples de réalisation de mémoires résistives.

Les mémoires résistives existantes présentent divers inconvénients, notamment des problèmes de fiabilité dans le temps, liés au fait que les niveaux de tension appliqués pour programmer les cellules élémentaires peuvent être relativement élevés. Il serait souhaitable de pouvoir disposer d'une mémoire résistive palliant tout ou partie de ces inconvénients.

### Résumé

Ainsi, un mode de réalisation prévoit un circuit mémoire comportant une pluralité de cellules élémentaires disposées selon des lignes et des colonnes, chaque cellule comportant :
un élément résistif programmable ayant une première extrémité reliée à un premier noeud de la cellule ; et
un transistor MOS de contrôle ayant un premier noeud de conduction relié à une deuxième extrémité de l'élément résistif, un deuxième noeud de conduction relié à un deuxième noeud de la cellule, et un noeud de commande relié à un troisième noeud de la cellule,
dans lequel, dans chaque ligne, les cellules de la ligne ont leurs premiers noeuds reliés à une même première piste conductrice de contrôle de la ligne et ont leurs troisièmes noeuds reliés à une même deuxième piste conductrice de contrôle de la ligne, et, dans chaque colonne, les cellules ont leurs deuxièmes noeuds reliés à une même piste conductrice de contrôle de la colonne,
le circuit mémoire comprenant en outre un circuit de contrôle adapté à mettre en oeuvre des opérations d'écriture et d'effacement de cellules élémentaires de la mémoire selon un mode de fonctionnement unipolaire, le circuit de contrôle étant adapté à, lors d'une phase d'écriture ou d'effacement d'une cellule :
   appliquer une première tension sur la piste conductrice de contrôle de la colonne comprenant la cellule à programmer ;
   appliquer une deuxième tension sur la première piste conductrice de contrôle de la ligne comprenant la cellule à programmer ;
   appliquer une troisième tension sur la deuxième piste conductrice de contrôle de la ligne comprenant la cellule à programmer, la troisième tension étant apte à rendre passant le transistor de contrôle de la cellule à programmer ;
   appliquer une quatrième tension sur les pistes conductrices de contrôle de colonnes ne comprenant pas la cellule à programmer, la quatrième tension étant apte à bloquer les transistors de contrôle dans les cellules comprises à la fois dans lesdites colonnes et dans la ligne comprenant la cellule à programmer ; et
   appliquer une cinquième tension sur les premières pistes conductrices de contrôle de lignes ne comprenant pas la cellule à programmer,
dans lequel :
   la cinquième tension est de niveau intermédiaire entre les première et deuxième tensions ; et/ou
   la quatrième tension est de niveau intermédiaire entre les première et deuxième tensions.

Selon un mode de réalisation, dans chaque cellule, le transistor de contrôle est un transistor MOS à canal N.

Selon un mode de réalisation, les deuxième et troisième tensions sont supérieures à la première tension, et la quatrième tension est supérieure à la troisième tension moins la tension de seuil du transistor de contrôle.

Selon un mode de réalisation, dans chaque cellule, le transistor de contrôle est un transistor MOS à canal P.

Selon un mode de réalisation, les deuxième et troisième tensions sont inférieures à la première tension, et la quatrième tension est inférieure à la troisième tension plus la tension de seuil du transistor de contrôle.

Selon un mode de réalisation, les quatrième et cinquième tensions sont de niveau intermédiaire entre les première et deuxième tensions.

Selon un mode de réalisation, les quatrième et cinquième tensions sont sensiblement égales.

Selon un mode de réalisation, les troisième, quatrième et cinquième tensions sont sensiblement égales.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique d'un exemple d'une cellule élémentaire d'une mémoire résistive ;
la figure 2 est un chronogramme illustrant un exemple d'un procédé de commande de la cellule de la figure 1 ;
la figure 3 est un schéma électrique d'une mémoire résistive comportant une pluralité de cellules élémentaires du type décrit en relation avec la figure 1 ;
la figure 4 est un schéma électrique d'un exemple d'un autre mode de réalisation d'une mémoire résistive ; et
la figure 5 est un schéma électrique d'un exemple d'un autre mode de réalisation d'une mémoire résistive.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, les circuits de contrôle disposés à la périphérie d'une mémoire résistive pour appliquer des signaux de contrôle appropriés aux cellules élémentaires de la mémoire n'ont pas été détaillés, la réalisation de tels circuits de contrôle étant à la portée de l'homme du métier à partir des indications fonctionnelles décrites dans la présente demande. Sauf précision contraire, les expressions "approximativement", "sensiblement", et "de l'ordre de" signifient à 10 % près, de préférence à 5 % près. Dans la présente demande, on utilise le terme "connecté" pour désigner une liaison électrique directe, sans composant électronique intermédiaire, par exemple au moyen d'une ou plusieurs pistes conductrices ou fils conducteurs, et le terme "couplé" ou le terme "relié", pour désigner une liaison électrique qui peut être directe (signifiant alors "connecté") ou indirecte (c'est-à-dire via un ou plusieurs composants intermédiaires).

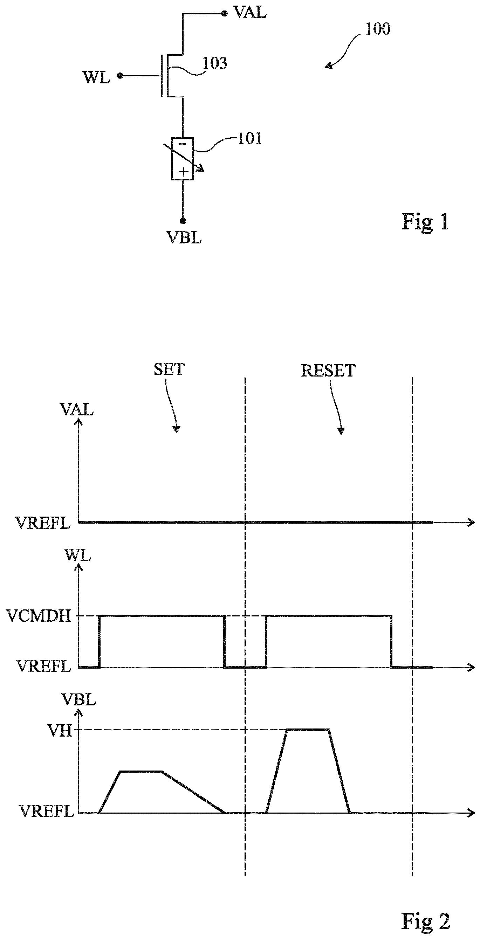

La figure 1 est un schéma électrique d'un exemple d'une cellule élémentaire 100 d'une mémoire résistive. Dans cet exemple, la cellule 100 comprend un unique élément résistif de stockage 101, par exemple de type PCM, et un unique transistor de contrôle 103. L'élément résistif 101 est compatible avec un fonctionnement unipolaire, c'est-à-dire qu'il est adapté à être écrit et effacé par application de tensions de même polarité entre ses électrodes. On notera que les éléments résistifs programmables adaptés à un mode de fonctionnement unipolaire présentent généralement un sens préférentiel d'application de la tension de programmation. Ainsi, les électrodes d'un élément résistif programmable d'une mémoire unipolaire sont le plus souvent différenciées, l'une des électrodes, appelée électrode négative ou cathode, étant destinée à recevoir le potentiel bas de la tension de programmation de l'élément, et l'autre électrode, appelée électrode positive ou anode, étant destinée à recevoir le potentiel haut de la tension de programmation. Dans l'exemple représenté, l'électrode négative de l'élément résistif 101 est désignée par un signe -, et l'électrode positive de l'élément résistif 101 est désignée par un signe +. L'électrode positive (+) de l'élément 101 est reliée à un premier noeud de contrôle VBL de la cellule, et l'électrode négative (-) de l'élément 101 est reliée à un premier noeud de conduction du transistor 103, le deuxième noeud de conduction du transistor 103 étant relié à un deuxième noeud de contrôle VAL de la cellule. La cellule 100 comprend en outre un troisième noeud de contrôle WL relié à la grille du transistor 103. Dans cet exemple, le transistor 103 est un transistor MOS à canal N.

La figure 2 est un chronogramme illustrant un exemple d'un procédé de commande de la cellule de la figure 1. Plus particulièrement, la figure 2 représente l'évolution, en fonction du temps, des tensions appliquées sur les noeuds de contrôle VAL, WL et VBL de la cellule 100 lors de phases d'écriture et d'effacement de la cellule.

Lors d'une phase d'écriture (SET) de la cellule 100, le noeud VAL, correspondant à la source du transistor 103, est mis à une tension de référence basse ou masse VREFL, par exemple une tension de l'ordre de 0 V, et une impulsion de tension de programmation de niveau haut par rapport à la tension de référence VREFL est appliquée sur le noeud VBL (initialement à la tension de référence VREFL). Pendant toute la durée de la phase d'écriture, le transistor de contrôle 103 de la cellule est maintenu passant par application d'une tension de niveau haut VCMDH (référencé à la masse) sur le noeud WL.

Lors d'une phase d'effacement (RESET) de la cellule 100, des tensions similaires sont appliquées sur les noeuds VAL, VBL et WL de la cellule 100, la principale différence résidant dans la forme de l'impulsion de tension de programmation de niveau haut appliquée sur le noeud VBL. Plus particulièrement, dans l'exemple de la figure 2, la pente du front descendant de l'impulsion de tension appliquée sur le noeud VBL pendant les phases d'effacement est supérieure à la pente du front descendant de l'impulsion de tension appliquée sur ce même noeud VBL pendant les phases d'écriture. De plus, dans cet exemple, la valeur maximale de l'impulsion de tension appliquée sur le noeud VBL pendant les phases d'effacement est supérieure à la valeur maximale de l'impulsion de tension appliquée sur ce même noeud VBL pendant les phases d'écriture. On désigne ici par VH le niveau maximal de tension (référencé à la masse) appliqué sur le noeud VBL pendant les phases d'écriture et d'effacement de la cellule. En pratique, le niveau VCMDH peut être inférieur au niveau VH. A titre d'exemple illustratif, les niveaux VH et VCMDH peuvent être respectivement de l'ordre de 2,5 V et de l'ordre de 1,8 V (dans le cas où la tension de référence est à 0 V, étant entendu que le fonctionnement décrit peut être obtenu en décalant tous les niveaux de tension vers le haut ou vers le bas).

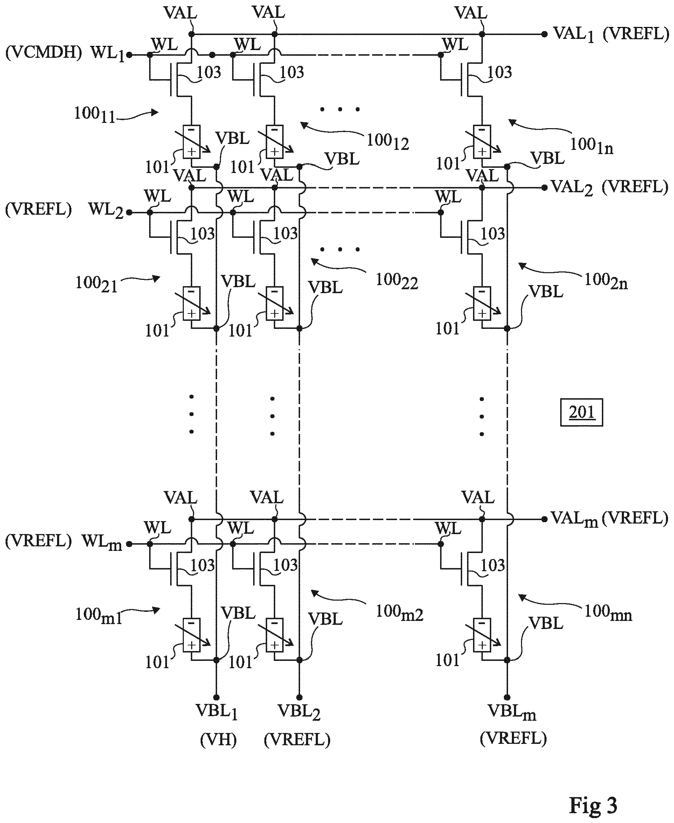

La figure 3 est un schéma électrique d'une mémoire résistive comportant une pluralité de cellules élémentaires 100ᵢⱼ du type décrit en relation avec la figure 1. Les cellules 100ᵢⱼ sont agencées en matrice selon m lignes et n colonnes, avec m et n entiers supérieurs à 1, i et j étant des indices désignant respectivement le rang de la ligne et le rang de la colonne à laquelle appartient chaque cellule, avec i entier allant de 1 à m et j entier allant de 1 à n. Les cellules 100ᵢⱼ sont par exemple identiques ou similaires. Dans chaque ligne de rang i de la matrice, les n cellules 100ᵢⱼ de la ligne ont leurs noeuds de contrôle VAL connectés à une même première piste conductrice VALᵢ de contrôle de la ligne, et ont leurs noeuds de contrôle WL connectés à une même deuxième piste conductrice WLᵢ de contrôle de la ligne. Dans chaque colonne de rang j de la matrice, les m cellules 100ᵢⱼ de la colonne ont leurs noeuds de contrôle VBL connectés à une même piste conductrice VBLⱼ de contrôle de la colonne. La mémoire de la figure 3 comprend en outre un circuit de contrôle 201 adapté à contrôler les tensions appliquées sur les pistes de contrôle VALᵢ, WLᵢ et VBLⱼ de la mémoire pour mettre en oeuvre des opérations d'écriture ou d'effacement de cellules élémentaires de la mémoire selon un mode de fonctionnement unipolaire du type décrit en relation avec la figure 2.

Le fonctionnement de la mémoire de la figure 3, mis en oeuvre par le circuit de contrôle 201, est le suivant. Pendant une phase d'écriture ou d'effacement d'une cellule 100ᵢⱼ de la matrice (la cellule 100₁₁ dans l'exemple représenté), la piste conductrice VALᵢ de la ligne à laquelle appartient la cellule est mise à la tension de référence basse VREFL, et une impulsion de tension de programmation de niveau haut, par exemple de niveau VH, est appliquée sur la piste conductrice VBLⱼ (initialement à la tension de référence VREFL) de la colonne à laquelle appartient la cellule. Pendant toute la durée de cette phase d'écriture ou d'effacement, le transistor de contrôle 103 de la cellule est maintenu passant par application d'une tension de niveau haut VCMDH sur la piste conductrice WLᵢ de la ligne à laquelle appartient la cellule. Pour éviter une commutation non désirée d'un élément résistif de stockage dans une autre cellule de la matrice, les pistes conductrices VALᵢ et WLᵢ des autres lignes de la matrice et les pistes conductrices VBLⱼ des autres colonnes de la matrice peuvent être maintenues à la tension de référence VREFL pendant toute la durée de la phase d'écriture ou d'effacement.

Un problème posé par ce mode de fonctionnement réside dans le stress relativement élevé subi par les transistors de contrôle 103 des cellules élémentaires non programmées de la ligne et de la colonne comprenant la cellule programmée. En effet, lors d'une phase d'écriture ou d'effacement d'une cellule 100ᵢⱼ, chacune des cellules de la colonne de rang j à l'exception de la cellule 100ᵢⱼ a son transistor de contrôle 103 commandé à l'état bloqué, et se voit appliquer une tension de niveau VH entre ses noeuds VBL et VAL. Dans le cas de transistors MOS, il en résulte un vieillissement accéléré et un risque de claquage des espaceurs des transistors 103 non activés de la colonne. De plus, dans chacune des cellules de la ligne de rang i à l'exception de la cellule 100ᵢⱼ le transistor de contrôle 103 de la cellule se voit appliquer une tension de niveau VCMDH sur sa grille, et une tension sensiblement nulle entre ses noeuds de conduction. Dans le cas de transistors MOS, il en résulte un vieillissement accéléré et un risque de claquage de l'oxyde de grille des transistors 103 non activés de la ligne. Pour éviter une dégradation prématurée des transistors 103, ces derniers peuvent être dimensionnés pour résister aux stress susmentionnés, mais ceci représente un coût en terme de surface semiconductrice occupée par les transistors, et constitue une limitation à l'augmentation de la densité de la mémoire.

Un autre problème posé par le mode de fonctionnement décrit ci-dessus est qu'il conduit à la circulation de courants de fuite parasites relativement élevés dans la mémoire. En particulier, lors d'une phase d'écriture ou d'effacement d'une cellule 100ᵢⱼ, un courant de programmation relativement élevé circule de la piste conductrice VALᵢ vers la piste conductrice VBLⱼ, à travers la cellule 100ᵢⱼ. Sous l'effet de ce courant, et du fait de la résistivité intrinsèque de la piste conductrice VALᵢ, il apparaît un gradient de potentiel sur la piste conductrice VALᵢ. Ainsi, dans chacune des cellules de la ligne de rang i, la tension sur le noeud VAL de la cellule peut prendre une valeur légèrement supérieure à la tension de référence appliquée à l'extrémité de la piste conductrice VALᵢ. Etant donné qu'une tension de commande à l'état passant de niveau VCMDH est appliquée sur les noeuds de commande WL de chacune des cellules de la ligne, des courants parasites relativement importants peuvent circuler dans les transistors 103 des cellules non activées de la ligne. De plus, dans chacune des cellules non activées de la colonne comprenant la cellule 100ᵢⱼ, des courants de fuite peuvent apparaître du fait de la tension source-drain relativement élevée appliquée aux transistors de contrôle 103.

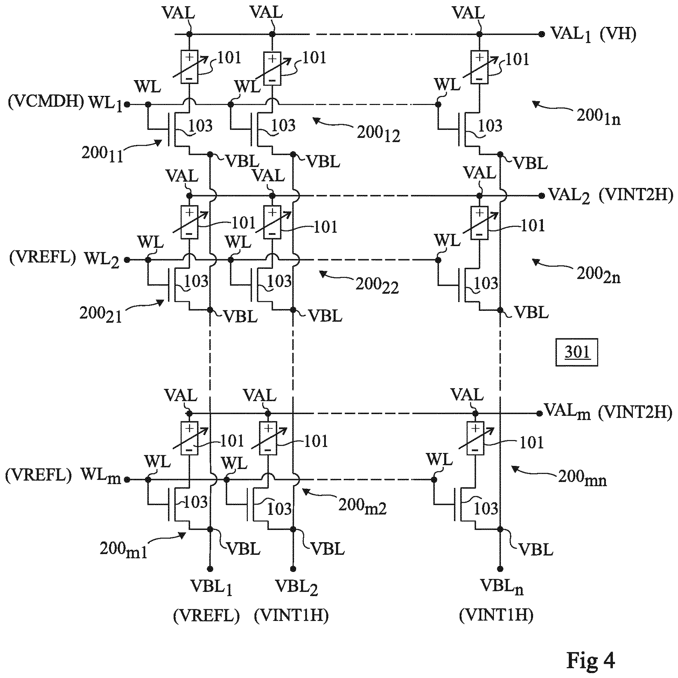

La figure 4 est un schéma électrique d'un exemple d'un mode de réalisation d'une mémoire résistive. La mémoire de la figure 4 comprend une pluralité de cellules élémentaires 200ᵢⱼ, par exemple identiques ou similaires. Les cellules élémentaires 200ᵢⱼ, comprennent les mêmes éléments que les cellules élémentaires 100ᵢⱼ de la mémoire de la figure 3, agencés différemment. En particulier, dans chaque cellule élémentaire 200ᵢⱼ de la mémoire de la figure 4, l'association en série de l'élément résistif 101 et du transistor 103 est retournée entre les noeuds de contrôle VAL et VBL de la cellule par rapport à la configuration décrite en relation avec les figures 1 et 3. Ainsi, dans la mémoire de la figure 4, dans chaque cellule élémentaire 200ᵢⱼ, l'électrode positive (+) de l'élément 101 est reliée au noeud de contrôle VAL de la cellule, et l'électrode négative (-) de l'élément 101 est reliée à un premier noeud de conduction du transistor 103, le deuxième noeud de conduction du transistor 103 étant relié au noeud de contrôle VBL de la cellule. De même que dans la configuration des figures 1 et 3, le troisième noeud de contrôle WL de la cellule est relié à la grille du transistor 103.

Les cellules élémentaires 200ᵢⱼ de la mémoire de la figure 4 sont agencées en matrice selon m lignes et n colonnes, de façon similaire ou identique à ce qui a été décrit en relation avec la figure 3. En particulier, dans chaque ligne de rang i de la matrice, les n cellules 200ᵢⱼ de la ligne ont leurs noeuds de contrôle VAL connectés à une même première piste conductrice VALᵢ de contrôle de la ligne, et ont leurs noeuds de contrôle WL connectés à une même deuxième piste conductrice WLᵢ de contrôle de la ligne, et, dans chaque colonne de rang j de la matrice, les m cellules 200ᵢⱼ de la colonne ont leurs noeuds de contrôle VBL connectés à une même piste conductrice VBLⱼ de contrôle de la colonne. La mémoire de la figure 4 comprend en outre un circuit de contrôle 301 adapté à contrôler les tensions appliquées sur les pistes de contrôle VALᵢ, WLᵢ et VBLⱼ de la mémoire pour mettre en oeuvre des opérations d'écriture ou d'effacement de cellules de la mémoire selon un mode de fonctionnement unipolaire.

Le fonctionnement de la mémoire de la figure 4, mis en oeuvre par le circuit de contrôle 301, est le suivant. Pendant une phase d'écriture ou d'effacement d'une cellule 200ᵢⱼ de la matrice (la cellule 200₁₁ dans l'exemple représenté), la piste conductrice VBLⱼ de la colonne à laquelle appartient la cellule est mise à la tension de référence VREFL, et une impulsion de tension de programmation de niveau haut, par exemple de niveau VH, est appliquée sur la piste conductrice VALᵢ (initialement à la tension de référence VREFL) de la ligne à laquelle appartient la cellule. Pendant toute la durée de cette phase d'écriture ou d'effacement, le transistor de contrôle 103 de la cellule est maintenu passant par application d'une tension de niveau haut VCMDH sur la piste conductrice WLᵢ de la ligne à laquelle appartient la cellule.

Par ailleurs, pendant toute la durée de la phase d'écriture ou d'effacement, pour éviter une commutation non désirée d'un élément résistif de stockage dans une autre cellule de la matrice, les pistes conductrices VBLⱼ des autres colonnes de la matrice peuvent être maintenues à une tension de niveau haut (c'est-à-dire supérieur à VREFL) VINT1H, les pistes conductrices VALᵢ des autres lignes de la matrice peuvent être maintenues à une tension de niveau haut (c'est-à-dire supérieur à VREFL) VINT2H, et les pistes conductrices WLᵢ des autres lignes de la matrice peuvent être maintenues à la tension de référence VREFL.

Le niveau VINT1H peut être choisi de façon à assurer le blocage des transistors 103 des cellules non activées de la ligne comprenant la cellule 200ᵢⱼ programmée, tout en limitant à un niveau acceptable la tension source-drain vue par ces transistors, par exemple à un niveau inférieur ou égal à la tension drain source nominale spécifiée pour ces transistors. En particulier, le niveau VINT1H est choisi supérieur à VCMDH-VTH, où VTH est la tension de seuil des transistors 103, de façon que la tension grille source des transistors 103 des cellules non activées de la ligne soit inférieure à la tension de seuil VTH des transistors 103. Le niveau VINT1H est par exemple sensiblement égal au niveau VCMDH. A titre de variante, le niveau VINT1H est compris dans la plage allant de VCMDH-VTH à VH.

Le niveau VINT2H peut être choisi de façon à limiter à un niveau acceptable la tension drain source des transistors 103 des autres lignes de la matrice, par exemple à un niveau inférieur ou égal à la tension drain source nominale spécifiée pour ces transistors. A titre d'exemple, le niveau VINT2H est inférieur au niveau VH. Le niveau VINT2H est par exemple sensiblement égal au niveau VINT1H, par exemple de l'ordre de VCMDH.

Par rapport à la configuration de la figure 3, un avantage du mode de réalisation de la figure 4 est que les transistors 103 des cellules non programmées de la ligne comprenant la cellule programmée ne subissent pas de stress important, ni au niveau de leur oxyde de grille (transistors 103 bloqués), ni au niveau de leurs espaceurs (tension drain source inférieure à VH). De plus, dans le mode de réalisation de la figure 4, les courants parasites dans les transistors 103 des cellules non programmées de la ligne comprenant la cellule programmée peuvent être rendus nuls ou négligeables.

Un autre avantage du mode de réalisation de la figure 4 est que les transistors 103 des cellules non programmées de la colonne comprenant la cellule programmée voient une tension drain source réduite par rapport à la configuration de la figure 3, d'où il résulte un stress réduit et des courants de fuite réduits.

Ainsi, dans le mode de réalisation de la figure 4, seule la cellule programmée est susceptible de subir un stress important. En particulier, seule la cellule programmée est susceptible de voir à ses bornes une tension de niveau VH. Il en résulte, à dimensionnements identiques des transistors 103, une endurance (durée de vie) et une fiabilité accrue de la mémoire par rapport à la configuration de la figure 3. De plus, la diminution des courants de fuite parasites permet de limiter la consommation électrique par rapport à la configuration de la figure 3.

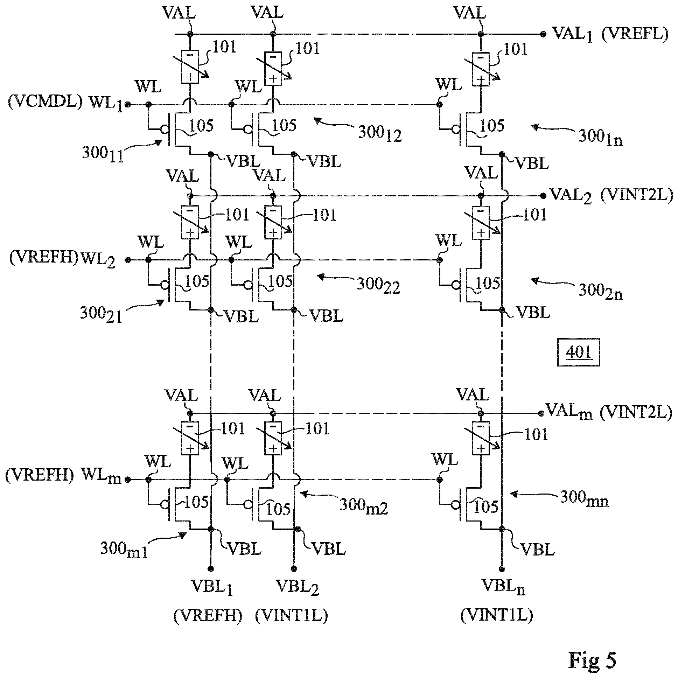

La figure 5 est un schéma électrique d'un exemple d'un autre mode de réalisation d'une mémoire résistive. Le mode de réalisation de la figure 5 diffère du mode de réalisation de la figure 4 en ce que, dans le mode de réalisation de la figure 5, les transistors de contrôle des cellules élémentaires de la mémoire sont des transistors MOS à canal P.

La mémoire de la figure 5 comprend une pluralité de cellules élémentaires 300ᵢⱼ, par exemple identiques ou similaires. Dans cet exemple, chaque cellule élémentaire 300ᵢⱼ comprend un unique élément résistif de stockage 101 du type décrit en relation avec les figures 1, 3 et 4, et un unique transistor de contrôle 105. Dans cet exemple, le transistor 105 est un transistor MOS à canal P. L'électrode négative (-) de l'élément 101 est reliée à un premier noeud de contrôle VAL de la cellule, et l'électrode positive (+) de l'élément 101 est reliée à un premier noeud de conduction du transistor 105, le deuxième noeud de conduction du transistor 105 étant relié à un deuxième noeud de contrôle VBL de la cellule. Chaque cellule élémentaire 300ᵢⱼ comprend en outre un troisième noeud de contrôle WL relié à la grille du transistor 105.

Les cellules élémentaires 300ᵢⱼ de la mémoire de la figure 5 sont agencées en matrice selon m lignes et n colonnes, de façon similaire ou identique à ce qui a été décrit en relation avec les figures 3 et 4. En particulier, dans chaque ligne de rang i de la matrice, les n cellules 300ᵢⱼ de la ligne ont leurs noeuds de contrôle VAL connectés à une même première piste conductrice VALᵢ de contrôle de la ligne, et ont leurs noeuds de contrôle WL connectés à une même deuxième piste conductrice WLᵢ de contrôle de la ligne, et, dans chaque colonne de rang j de la matrice, les m cellules 300ᵢⱼ de la colonne ont leurs noeuds de contrôle VBL connectés à une même piste conductrice VBLⱼ de contrôle de la colonne. La mémoire de la figure 5 comprend en outre un circuit de contrôle 401 adapté à contrôler les tensions appliquées sur les pistes de contrôle VALᵢ, WLᵢ et VBLⱼ de la mémoire pour mettre en oeuvre des opérations d'écriture ou d'effacement de cellules de la mémoire selon un mode de fonctionnement unipolaire.

Le fonctionnement de la mémoire de la figure 5, mis en oeuvre par le circuit de contrôle 401, est le suivant. Pendant une phase d'écriture ou d'effacement d'une cellule 300ᵢⱼ de la matrice (la cellule 300₁₁ dans l'exemple représenté), la piste conductrice VBLⱼ de la colonne à laquelle appartient la cellule est mise à une tension de référence haute (c'est-à-dire supérieure à la tension de référence basse VREFL) VREFH, par exemple de niveau VH, et une impulsion de tension de programmation de niveau bas, c'est-à-dire inférieure à la tension de référence haute VREFH, est appliquée sur la piste conductrice VALᵢ (initialement à la tension de référence haute VREFH) de la ligne à laquelle appartient la cellule. Le niveau et la forme de l'impulsion de tension de programmation de niveau bas appliquée sur la piste VALᵢ sont choisis en fonction de l'état dans lequel on souhaite programmer la cellule. A titre d'exemple, par analogie avec le mode de fonctionnement de la figure 2, si le niveau de la tension de référence haute VREFH est égal à VH, le niveau, c'est-à-dire la valeur minimale, de l'impulsion de tension de programmation de niveau bas appliquée sur la piste VALᵢ, peut être de l'ordre de la tension de référence basse VREFL dans le cas d'une opération d'effacement, ou supérieur à la tension de référence basse VREFL dans le cas d'une opération d'écriture. Pendant toute la durée de la phase d'écriture ou d'effacement, le transistor de contrôle 105 de la cellule est maintenu passant par application d'une tension de niveau bas (c'est-à-dire inférieur à VREFH) VCMDL sur la piste conductrice WLᵢ de la ligne à laquelle appartient la cellule.

Par ailleurs, pendant toute la durée de la phase d'écriture ou d'effacement, pour éviter une commutation non désirée d'un élément résistif de stockage dans une autre cellule de la matrice, les pistes conductrices VBLⱼ des autres colonnes de la matrice peuvent être maintenues à une tension de niveau bas (inférieur à VREFH) VINT1L, les pistes conductrices VALᵢ des autres lignes de la matrice peuvent être maintenues à une tension de niveau bas (inférieur à VREFH) VINT2L, et les pistes conductrices WLᵢ des autres lignes de la matrice peuvent être maintenues à la tension de référence haute VREFH.

Le niveau VINT1L peut être choisi de façon à assurer le blocage des transistors 105 des cellules non activées de la ligne comprenant la cellule 300ᵢⱼ programmée, tout en limitant à un niveau acceptable la tension source-drain vue par ces transistors, par exemple à un niveau inférieur ou égal à la tension drain source nominale spécifiée pour ces transistors. En particulier, le niveau VINT1L est choisi inférieur à VCMDL+VTH, où VTH est la tension de seuil des transistors 105, de façon que la tension source grille des transistors 105 des cellules non activées de la ligne soit inférieure à la tension de seuil VTH des transistors 105. Le niveau VINT1L est par exemple sensiblement égal au niveau VCMDL. A titre de variante, le niveau VINT1L est compris dans la plage allant de VCMDL+VTH à VREFL.

Le niveau VINT2L peut être choisi de façon à limiter à un niveau acceptable la tension drain source des transistors 105 des autres lignes de la matrice, par exemple à un niveau inférieur ou égal à la tension drain source nominale spécifiée pour ces transistors. A titre d'exemple, le niveau VINT2L est supérieur au niveau VREFL. Le niveau VINT2L est par exemple sensiblement égal au niveau VINT1L, par exemple de l'ordre de VCMDL.

Des modes de réalisation particuliers ont été décrits. Diverses variantes et modifications apparaîtront à l'homme de l'art. En particulier, les modes de réalisation décrits ne se limitent pas aux exemples susmentionnés dans lequel l'élément résistif programmable de base de la mémoire est de type PCM. Plus généralement, les modes de réalisation décrits peuvent être adaptés à tout type d'élément résistif programmable compatible avec un fonctionnement unipolaire, par exemple des éléments résistifs programmables de type OxRAM unipolaire, ainsi que tous les éléments résistifs programmables dans lesquels la polarité du courant de programmation n'importe pas, par exemple les éléments résistifs dans lesquels la programmation se fait par effet joule.

En outre, les modes de réalisation décrits ne se limitent pas au cas particulier décrit ci-dessus dans lequel les électrodes de l'élément résistif programmable de base de la mémoire sont différentiées (anode/cathode). Les modes de réalisation décrits ci-dessus sont aussi compatibles avec des éléments résistifs programmables symétriques ou « non polaires ».

Par ailleurs, bien que l'on ait décrit ci-dessus uniquement des exemples de procédés de commande dans lesquels une unique cellule élémentaire de la mémoire est programmée, les modes de réalisation décrits ci-dessus sont compatibles avec un fonctionnement dans lequel plusieurs cellules élémentaires d'une même ligne ou d'une même colonne sont programmées simultanément. A titre d'exemple, dans le mode de réalisation de la figure 4, pour programmer simultanément plusieurs cellules d'une même colonne, plusieurs impulsions de tension de programmation de niveau haut peuvent être appliquées simultanément sur les pistes conductrices de contrôle VALᵢ des lignes comprenant les cellules à programmer. Pour programmer simultanément plusieurs cellules d'une même ligne, la piste conductrice de contrôle VALᵢ de la ligne peut être maintenue à une tension de référence haute VREFH, par exemple de niveau VH, pendant toute la durée de la phase de programmation, et des impulsions de tension de programmation de niveau bas, c'est-à-dire inférieur à VREFH, peuvent être appliquées simultanément sur les pistes conductrices de contrôle VBLⱼ (initialement au niveau VREFH ou au niveau VINT1) des colonnes comprenant les cellules à programmer.

## Revendications

1. Circuit mémoire comportant une pluralité de cellules élémentaires (200ᵢⱼ ; 300ᵢⱼ) disposées selon des lignes et des colonnes, chaque cellule comportant :
un élément résistif (101) programmable ayant une première extrémité reliée à un premier noeud (VAL) de la cellule ; et
un transistor MOS de contrôle (103 ; 105) ayant un premier noeud de conduction relié à une deuxième extrémité de l'élément résistif (101), un deuxième noeud de conduction relié à un deuxième noeud (VBL) de la cellule, et un noeud de commande relié à un troisième noeud (WL) de la cellule,
dans lequel, dans chaque ligne, les cellules (200ᵢⱼ ; 300ᵢⱼ) de la ligne ont leurs premiers noeuds (VAL) reliés à une même première piste conductrice (VALᵢ) de contrôle de la ligne et ont leurs troisièmes noeuds (WL) reliés à une même deuxième piste conductrice (WLᵢ) de contrôle de la ligne, et, dans chaque colonne, les cellules (200ᵢⱼ, 300ᵢⱼ) ont leurs deuxièmes noeuds (VBL) reliés à une même piste conductrice (VBLⱼ) de contrôle de la colonne,
le circuit mémoire comprenant en outre un circuit de contrôle (301 ; 401) adapté à mettre en oeuvre des opérations d'écriture et d'effacement de cellules élémentaires de la mémoire selon un mode de fonctionnement unipolaire, le circuit de contrôle étant adapté à, lors d'une phase d'écriture ou d'effacement d'une cellule (200ᵢⱼ ; 300ᵢⱼ) :
appliquer une première tension (VREFL ; VREFH) sur la piste conductrice (VBLⱼ) de contrôle de la colonne comprenant la cellule (200ᵢⱼ ; 300ᵢⱼ) à programmer ;
appliquer une deuxième tension (VH ; VREFL) sur la première piste conductrice (VALᵢ) de contrôle de la ligne comprenant la cellule (200ᵢⱼ ; 300ᵢⱼ) à programmer ;
appliquer une troisième tension (VCMDH ; VCMDL) sur la deuxième piste conductrice (WLᵢ) de contrôle de la ligne comprenant la cellule (200ᵢⱼ ; 300ᵢⱼ) à programmer, la troisième tension étant apte à rendre passant le transistor de contrôle (103 ; 105) de la cellule (200ᵢⱼ ; 300ᵢⱼ) à programmer ;
appliquer une quatrième tension (VINT1H, VINT1L) sur les pistes conductrices (VBLⱼ) de contrôle de colonnes ne comprenant pas la cellule (200ᵢⱼ ; 300ᵢⱼ) à programmer, la quatrième tension étant apte à bloquer les transistors de contrôle (103 ; 105) dans les cellules comprises à la fois dans lesdites colonnes et dans la ligne comprenant la cellule (200ᵢⱼ ; 300ᵢⱼ) à programmer ; et
appliquer une cinquième tension (VINT2H ; VINT2L) sur les premières pistes conductrices (VALᵢ) de contrôle de lignes ne comprenant pas la cellule (200ᵢⱼ ; 300ᵢⱼ) à programmer,
**caractérisé en ce que** :
la cinquième tension (VINT2H ; VINT2L) est de niveau intermédiaire entre les première (VREFL ; VREFH) et deuxième (VH ; VREFL) tensions ; et/ou
la quatrième tension (VINT1H ; VINT1L) est de niveau intermédiaire entre les première (VREFL ; VREFH) et deuxième (VH ; VREFL) tensions.

2. Circuit mémoire selon la revendication 1, dans lequel, dans chaque cellule, le transistor de contrôle (103) est un transistor MOS à canal N.

3. Circuit mémoire selon la revendication 2, dans lequel les deuxième (VH) et troisième (VCMDH) tensions sont supérieures à la première tension (VREFL), et la quatrième tension (VINT1H) est supérieure à la troisième tension (VCMDH) moins la tension de seuil (VTH) du transistor de contrôle (103).

4. Circuit mémoire selon la revendication 1, dans lequel, dans chaque cellule, le transistor de contrôle (105) est un transistor MOS à canal P.

5. Circuit mémoire selon la revendication 4, dans lequel les deuxième (VREFL) et troisième (VCMDL) tensions sont inférieures à la première tension (VREFH), et la quatrième tension (VINT1L) est inférieure à la troisième tension (VCMDL) plus la tension de seuil (VTH) du transistor de contrôle (105).

6. Circuit mémoire selon l'une quelconque des revendications 1 à 5, dans lequel les quatrième (VINT1H ; VINT1L) et cinquième (VINT2H ; VINT2L) tensions sont de niveau intermédiaire entre les première (VREFL ; VREFH) et deuxième (VH ; VREFL) tensions.

7. Circuit mémoire selon l'une quelconque des revendications 1 à 6, dans lequel les quatrième (VINT1H ; VINT1L) et cinquième (VINT2H ; VINT2L) tensions sont sensiblement égales.

8. Circuit mémoire selon l'une quelconque des revendications 1 à 7, dans lequel les troisième (VCMDH ; VCMDL), quatrième (VINT1H ; VINT1L) et cinquième (VINT2H ; VINT2L) tensions sont sensiblement égales.

## Patentansprüche

1. Speicherschaltung mit einer Vielzahl von Elementarzellen (200ᵢⱼ; 300ᵢⱼ), die in Reihen und Spalten angeordnet sind, wobei jede Zelle folgendes aufweist:
ein programmierbares Widerstandselement (101) mit einem ersten Ende, das mit einem ersten Knoten (VAL) der Zelle verbunden ist; und
einen MOS-Steuertransistor (103; 105) mit einem ersten leitenden Knoten, der mit einem zweiten Ende des Widerstandselements (101) verbunden ist, einem zweiten leitenden Knoten, der mit einem zweiten Knoten (VBL) der Zelle verbunden ist, und einem Steuerknoten, der mit einem dritten Knoten (WL) der Zelle verbunden ist,
wobei in jeder Reihe die Zellen (200ᵢⱼ; 300ᵢⱼ) in der Reihe ihre ersten Knoten (VAL) mit einer gleichen ersten Reihensteuerungsleiterbahn (VALᵢ) verbunden sind und ihre dritten Knoten (WL) mit einer gleichen zweiten Reihensteuerungsleiterbahn (WLᵢ) verbunden sind, und, in jeder Spalte, die Zellen (200ᵢⱼ, 300ᵢⱼ) ihre zweiten Knoten (VBL) mit einer gleichen Spaltensteuerungsleiterbahn (VBLⱼ) verbunden sind,
die Speicherschaltung ferner eine Steuerschaltung (301; 401) aufweist, die geeignet ist, Operationen zum Einstellen und Zurücksetzen von Elementarzellen des Speichers gemäß einer unipolaren Betriebsart durchzuführen, wobei die Steuerschaltung geeignet ist, während eines Schrittes zum Einstellen oder Zurücksetzen einer Zelle (200ᵢⱼ; 300ᵢⱼ) zum:
Anlegen einer ersten Spannung (VREFL; VREFH) an die Leiterbahn (VBLⱼ), die die Spalte steuert, die die zu programmierende Zelle (200ᵢⱼ; 300ᵢⱼ) aufweist;
Anlegen einer zweiten Spannung (VH; VREFL) an die erste Leiterbahn (VA-Lᵢ), die die Reihe mit der zu programmierenden Zelle (200ᵢⱼ; 300ᵢⱼ) steuert;
Anlegen einer dritten Spannung (VCMDH; VCMDL) an die zweite Leiterbahn (WLᵢ), die die Reihe steuert, die die zu programmierende Zelle (200ᵢⱼ; 300ᵢⱼ) aufweist, wobei die dritte Spannung den Steuertransistor (103; 105) der zu programmierenden Zelle (200ᵢⱼ; 300ᵢⱼ) einschalten kann;
Anlegen einer vierten Spannung (VINT1H, VINT1L) an die Leiterbahnen (VBLⱼ), die Spalten steuern, die nicht die zu programmierende Zelle (200ᵢⱼ; 300ᵢⱼ) aufweisen, wobei die vierte Spannung geeignet ist, die Steuertransistoren (103; 105) in den Zellen auszuschalten, die sowohl in den Spalten als auch in der Reihe, die die zu programmierende Zelle (200ᵢⱼ; 300ᵢⱼ) aufweist, enthalten sind; und
Anlegen einer fünften Spannung (VINT2H; VINT2L) an die ersten Leiterbahnen (VALᵢ), die Reihen steuern, die nicht die zu programmierende Zelle (200ᵢⱼ; 300ᵢⱼ) aufweisen,
**dadurch gekennzeichnet, dass**:
die fünfte Spannung (VINT2H; VINT2L) einen Pegel zwischen den ersten (VREFL; VREFH) und zweiten (VH; VREFL) Spannungen aufweist; und/oder die vierte Spannung (VINT1H; VINT1L) einen Pegel zwischen der ersten (VREFL; VREFH) und zweiten (VH; VREFL) Spannung aufweist.

2. Speicherschaltung nach Anspruch 1, wobei der Steuertransistor (103) in jeder Zelle ein N-Kanal-MOS-Transistor ist.

3. Speicherschaltung nach Anspruch 2, wobei die zweiten (VH) und dritten (VCMDH) Spannungen größer sind als die erste Spannung (VREFL) und die vierte Spannung (VINT1H) größer ist als die dritte Spannung (VCMDH) abzüglich der Schwellenspannung (VTH) des Steuertransistors (103).

4. Speicherschaltung nach Anspruch 1, wobei der Steuertransistor (105) in jeder Zelle ein P-Kanal-MOS-Transistor ist.

5. Speicherschaltung nach Anspruch 4, wobei die zweite (VREFL) und dritte (VCMDL) Spannung kleiner als die erste Spannung (VREFH) und die vierte Spannung (VINT1L) kleiner als die dritte Spannung (VCMDL) plus die Schwellenspannung (VTH) des Steuertransistors (105) ist.

6. Speicherschaltung nach einem der Ansprüche 1 bis 5, wobei die vierten (VINT1H, VINT1L) und fünften (VINT2H; VINT2L) Spannungen einen Pegel zwischen den ersten (VREFL; VREFH) und zweiten (VH; VREFL) Spannungen aufweisen.

7. Speicherschaltung nach einem der Ansprüche 1 bis 6, wobei die vierten (VINT1H; VINT1L) und fünften (VINT2H; VINT2L) Spannungen im Wesentlichen gleich sind.

8. Speicherschaltung nach einem der Ansprüche 1 bis 7, wobei die dritten (VCMDH; VCMDL), vierten (VINT1H; VINT1L) und fünften (VINT2H; VINT2L) Spannungen im Wesentlichen gleich sind.

## Claims

1. A memory circuit comprising a plurality of elementary cells (200ᵢⱼ; 300ᵢⱼ) arranged in rows and in columns, each cell comprising:
a programmable resistive element (101) having a first end connected to a first node (VAL) of the cell; and
a MOS control transistor (103; 105) having a first conduction node connected to a second end of the resistive element (101), a second conduction node connected to a second node (VBL) of the cell, and a control node connected to a third node (WL) of the cell,
wherein, in each row, the cells (200ᵢⱼ; 300ᵢⱼ) in the row have their first nodes (VAL) connected to a same first row control conductive track (VALᵢ) and have their third nodes (WL) connected to a same second row control conductive track (WLᵢ), and, in each column, the cells (200ᵢⱼ, 300ᵢⱼ) have their second nodes (VBL) connected to a same column control conductive track (VBLⱼ),
the memory circuit further comprising a control circuit (301; 401) capable of implementing operations of setting and resetting elementary cells of the memory according to a unipolar operating mode, the control circuit being capable of, during a step of setting or resetting a cell (200ᵢⱼ; 300ᵢⱼ) :
applying a first voltage (VREFL; VREFH) to the conductive track (VBLⱼ) controlling the column comprising the cell (200ᵢⱼ; 300ᵢⱼ) to be programmed;
applying a second voltage (VH; VREFL) to the first conductive track (VALᵢ) controlling the row comprising the cell (200ᵢⱼ; 300ᵢⱼ) to be programmed;
applying a third voltage (VCMDH; VCMDL) to the second conductive track (WLᵢ) controlling the row comprising the cell (200ᵢⱼ; 300ᵢⱼ) to be programmed, the third voltage being capable of turning on the control transistor (103; 105) of the cell (200ᵢⱼ; 300ᵢⱼ) to be programmed;
applying a fourth voltage (VINT1H, VINT1L) to the conductive tracks (VBLⱼ) controlling columns which do not comprise the cell (200ᵢⱼ; 300ᵢⱼ) to be programmed, the fourth voltage being capable of turning off the control transistors (103; 105) in the cells comprised both in said columns and in the row comprising the cell (200ᵢⱼ; 300ᵢⱼ) to be programmed; and
applying a fifth voltage (VINT2H; VINT2L) to the first conductive tracks (VALᵢ) controlling rows which do not comprise the cell (200ᵢⱼ; 300ᵢⱼ) to be programmed,
**characterized in that**:
the fifth voltage (VINT2H; VINT2L) has a level intermediate between the first (VREFL; VREFH) and second (VH; VREFL) voltages; and/or
the fourth voltage (VINT1H; VINT1L) has a level intermediate between the first (VREFL; VREFH) and second (VH; VREFL) voltages.

2. The memory circuit of claim 1, wherein, in each cell, the control transistor (103) is an N-channel MOS transistor.

3. The memory circuit of claim 2, wherein the second (VH) and third (VCMDH) voltages are greater than the first voltage (VREFL), and the fourth voltage (VINT1H) is greater than the third voltage (VCMDH) minus the threshold voltage (VTH) of the control transistor (103).

4. The memory circuit of claim 1, wherein, in each cell, the control transistor (105) is a P-channel MOS transistor.

5. The memory circuit of claim 4, wherein the second (VREFL) and third (VCMDL) voltages are smaller than the first voltage (VREFH), and the fourth voltage (VINT1L) is smaller than the third voltage (VCMDL) plus the threshold voltage (VTH) of the control transistor (105).

6. The memory circuit of any of claims 1 to 5, wherein the fourth (VINT1H, VINT1L) and fifth (VINT2H; VINT2L) voltages have a level intermediate between the first (VREFL; VREFH) and second (VH; VREFL) voltages.

7. The memory circuit of any of claims 1 to 6, wherein the fourth (VINT1H; VINT1L) and fifth (VINT2H; VINT2L) voltages are substantially equal.

8. The memory circuit of any of claims 1 to 7, wherein the third (VCMDH; VCMDL), fourth (VINT1H; VINT1L) and fifth (VINT2H; VINT2L) voltages are substantially equal.
